(19) Europäisches Patentamt
European Patent Office
Office européen des brevets

(11) **EP 2 467 851 B1**

(12) **EUROPEAN PATENT SPECIFICATION**

(45) Date of publication and mention
of the grant of the patent:
**15.06.2016 Bulletin 2016/24**

(51) Int Cl.:
***G10L 19/00*** *(2013.01)*

(21) Application number: **10810098.3**

(86) International application number:
**PCT/KR2010/004976**

(22) Date of filing: **29.07.2010**

(87) International publication number:
**WO 2011/021790 (24.02.2011 Gazette 2011/08)**

(54) **MULTI-CHANNEL AUDIO DECODING METHOD AND APPARATUS THEREFORE**

MEHRKANAL-AUDIODEKODIERVERFAHREN UND VORRICHTUNG DAFÜR

PROCÉDÉ DE DÉCODAGE AUDIO MULTICANAL ET APPAREIL CORRESPONDANT

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **18.08.2009 KR 20090076341**

(43) Date of publication of application:
**27.06.2012 Bulletin 2012/26**

(73) Proprietor: **Samsung Electronics Co., Ltd.**
**Suwon-si, Gyeonggi-do, 443-742 (KR)**

(72) Inventors:
• **KIM, Hyun-Wook**
**Suwon-si**
**Gyeonggi-do 441-930 (KR)**
• **JEONG, Jong-Hoon**
**Suwon-si**
**Gyeonggi-do 443-470 (KR)**
• **MOON, Han-Gil**
**Seoul 158-072 (KR)**

(74) Representative: **Appleyard Lees IP LLP**
**15 Clare Road**
**Halifax HX1 2HY (GB)**

(56) References cited:
**WO-A1-2006/003813     US-A- 5 222 189**
**US-A1- 2003 161 477     US-A1- 2007 140 499**
**US-A1- 2008 002 842     US-A1- 2009 063 140**
**US-A1- 2009 157 411**

## Description

### Technical Field

Exemplary embodiments of the present invention relates to a multi-channel audio system being compatible with a MPEG-1 Audio Layer 3 (MP3) decoder, and more particularly, to a multi-channel audio decoding method and apparatus therefor being compatible with an MP3 decoder and having low complexity.

### Background Art

Recently, a multi-channel decoder being compatible with MPEG-1 Audio Layer 3 (MP3) audio is widely used.

An MP3 decoder restores a stereo audio signal by decoding an audio bitstream.

The multi-channel decoder restores the stereo audio signal, which has been restored by the MP3 decoder, into a multi-channel audio signal by using additional information.

Also, the MP3 decoder and the multi-channel decoder includes a plurality of coefficient converters each including a Quadrature Mirror Filter (QMF) analyzer and a QMF synthesizer.

Background document US2008002842 discloses an addition to the two stereo channels L and R of MP3 audio, an additional center channel C, two surround channels Ls, Rs and optionally a low frequency enhancement channel or subwoofer channel.

### Disclosure of Invention

### Technical Problem

Most of the coefficient converters cause complexity to the multi-channel decoder that is compatible with the MP3 audio.

Thus, it is necessary to develop a solution to improve the complexity of the multi-channel decoder that is compatible with the MP3 audio

### Solution to Problem

Exemplary embodiments of the present invention provides a multi-channel audio decoding method and apparatus therefors being compatible with an MPEG-1 Audio Layer 3 (MP3) decoder and having low complexity.

### Advantageous Effects of Invention

According to the exemplary embodiment, it is possible to improve the complexity of transformation of a signal by using the serial conversion unit, instead of using the first PQMF synthesizing unit, the PQMF analyzing unit, and the second PQMF synthesizing unit0 according to the related art.

### Brief Description of Drawings

The above and other features of the present invention will become more apparent by describing in detail exemplary embodiments thereof with reference to the attached drawings in which:

FIG. 1(A) is a block diagram of a common multi-channel encoding apparatus;
FIG. 1(B) is a detailed block diagram of an MPEG-1 Audio Layer 3 (MP3) encoder;
FIGS. 2(A) through 2(D) are overviews of a frequency domain exhibiting downsampling operations of sub-bands in the MP3 encoder;
FIG. 3 is a diagram of a multi-channel decoding apparatus being compatible with a common MP3 decoder;
FIG. 4 is a diagram of a multi-channel decoding apparatus being compatible with a MP3 decoder, according to an exemplary embodiment of the present invention;
FIG. 5 is a diagram of a relationship between an input signal and an output signal in a serial conversion unit in FIG. 4;
FIG. 6 is a detailed diagram of the serial conversion unit in FIG. 4;
FIG. 7(A) is a detailed flowchart of operations performed by the serial conversion unit in FIG. 4;
FIG. 7(B) is a graph related to dividing a band into a plurality of domains, which is described with reference to FIG. 7(A); and
FIG. 8 is a flowchart of a multi-channel audio signal decoding method being compatible with a MP3 decoder, according to an exemplary embodiment of the present invention.

**Best Mode for Carrying out the Invention**

According to an aspect of the present invention, there is provided a multi-channel audio decoding method including the operations of decoding filter bank coefficients of a plurality of bands from a bitstream having a predetermined format; performing frequency transformation on the decoded filter bank coefficients of the plurality of bands, with respect to each of the plurality of bands; compensating for a phase of each of the plurality of bands according to a predetermined phase compensation value, and serially band-synthesizing the frequency-transformed coefficients of each of the plurality of bands on a frequency domain; and decoding a multi-channel audio signal from the band-synthesized frequency-transformed coefficients.

The operation of serially band-synthesizing may include the operations of setting a phase compensation value and a phase respond value; dividing the plurality of bands into even bands and odd bands, and dividing each of the divided plurality of bands into a plurality of domains; calculating a phase shift value of each of the plurality of domains based on the phase compensation value and the phase respond value, and compensating for the phase of each of the plurality of bands according to the calculated phase shift value; and serially synthesizing the frequency-transformed coefficients of the phase-compensated even and odd bands.

According to another aspect of the present invention, there is provided a multi-channel audio decoding apparatus including an MPEG-1 Audio Layer 3 (MP3) decoding core unit for decoding filter bank coefficients of a plurality of bands from an MP3 bitstream; a fast Fourier transform (FFT) unit for performing FFT on the filter bank coefficients of the plurality of bands, which are decoded by the MP3 decoding core unit, with respect to each of the plurality of bands; a serial conversion unit for shifting a phase of each of the plurality of bands which are FFT-performed by the FFT unit, according to a predetermined phase compensation value, and serially band-synthesizing FFT coefficients of each of the plurality of bands on a frequency domain; and a multi-channel decoding core unit for decoding a multi-channel audio signal from the FFT coefficients that are band-synthesized by the serial conversion unit.

The serial conversion unit may include a band domain dividing unit for dividing the plurality of bands into even bands and odd bands, and dividing each of the plurality of divided bands into a predetermined number of domains; a band domain phase compensating unit for calculating a phase shift value of each of the plurality of domains obtained by the dividing by the band domain dividing unit, based on the predetermined phase compensation value and a predetermined phase respond value, and compensating for the phase of each of the plurality of bands according to the calculated phase shift value; and a band synthesizing unit for serially synthesizing the FFT coefficients of the even and odd bands which are phase-compensated by the band domain phase compensating unit.

**Mode for the Invention**

Hereinafter, the present invention will be described in detail by explaining exemplary embodiments of the invention with reference to the attached drawings.

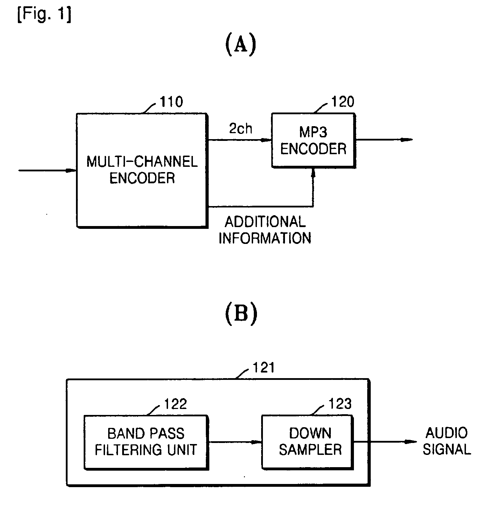

FIG. 1(A) is a block diagram of a common multi-channel encoding apparatus. FIG. 1(B) is a block diagram of a Pseudo-Quadrature Mirror Filter (PQMF) analyzing unit 121 in an MPEG-1 Audio Layer 3 (MP3) encoder 120 of FIG. 1(A).

A multi-channel encoder 110 downmixes a multi-channel signal into a two-channel audio signal, and encodes additional information for restoration of the multi-channel signal.

The MP3 encoder 120 encodes a stereo bitstream by using the two-channel audio signal and the additional information which are input from the multi-channel encoder 110.

Also, as illustrated in FIG. 1(B), the MP3 encoder 120 includes the PQMF analyzing unit 121 so as to encode the two-channel audio signal.

The PQMF analyzing unit 121 includes a band pass filtering unit 122 and a down sampler 123.

The band pass filtering unit 122 converts the two-channel audio signal on a time axis into an audio signal formed of a plurality of sub-bands.

The down sampler 123 converts the audio signal output from the band pass filtering unit 122 into a downsampled audio signal.

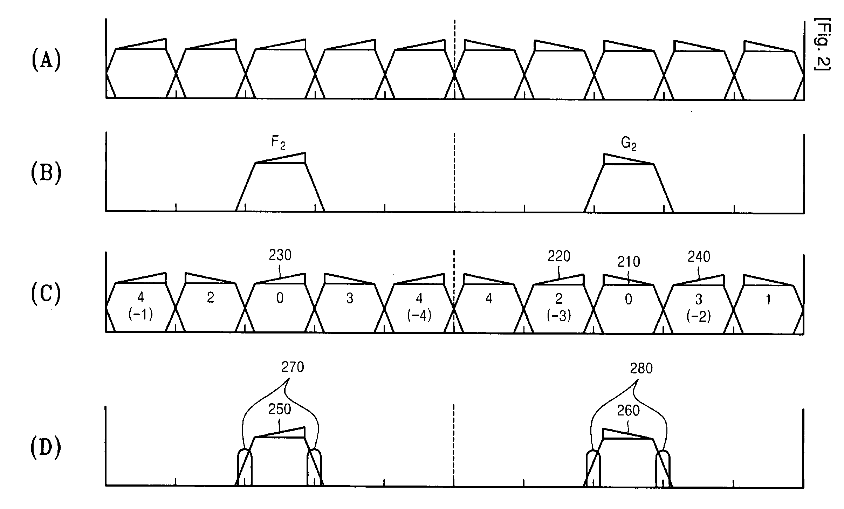

FIGS. 2(A) through 2(D) are overviews of a frequency domain exhibiting downsampling operations of sub-bands in the MP3 encoder 120.

FIG. 2(A) illustrates a characteristic of downsample filters of 5 sub-bands, FIG. 2(B) illustrates an output spectrum of the downsample filter with respect to the second sub-band, FIG. 2(C) illustrates a downsampled and interpolated spectrum with respect to the second sub-band, and FIG. 2(D) illustrates a spectrum of the second sub-band having passed through a low pass filter.

Referring to FIG. 2(C), a signal of a $k_{th}$ band $G_k$ 210 that corresponds to an original signal is affected by a $k_{th}$

duplicated signal 220 of a signal $F_k$ 230 and a $(k+1)_{th}$ duplicated signal 240.

Referring to FIG. 2(D), sub-bands 250 and 260 that have passed through the low pass filter include aliasing components 270 and 280 at their borders. The aliasing components 270 and 280 at borders between sub-bands shift a phase of a signal. Thus, one or more exemplary embodiments of the present invention compensate for a phase shift of a signal so as to remove the aliasing components 270 and 280 at the borders between the sub-bands, wherein the aliasing components 270 and 280 are generated by downsampling.

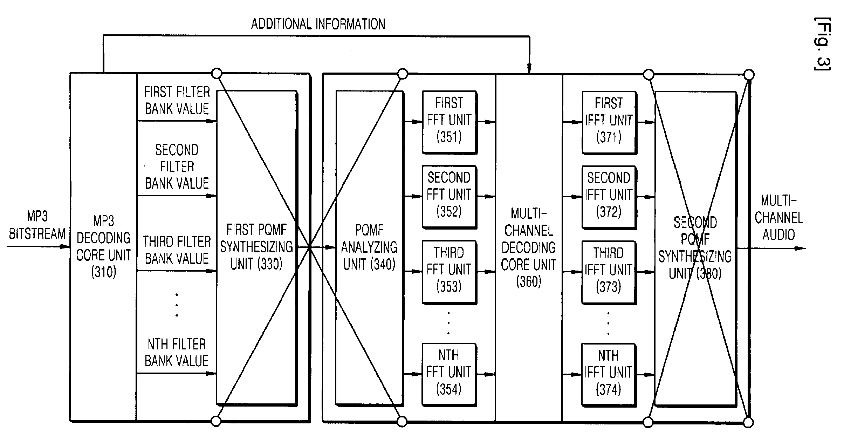

FIG. 3 is a diagram of a multi-channel decoding apparatus being compatible with a common MP3 decoder.

The multi-channel decoding apparatus being compatible with the common MP3 in FIG. 3 is divided into an MP3 decoder and a multi-channel decoder. The MP3 decoder includes a MP3 decoding core unit 310 and a first PQMF synthesizing unit 330, and the multi-channel decoder includes a PQMF analyzing unit 340, a first-$n_{th}$ fast Fourier transform (FFT) unit 351 through 354, a multi-channel decoding core unit 360, a first-$n_{th}$ inverse fast Fourier transform (IFFT) units 371 through 374, and a second PQMF synthesizing unit 380 (here, n is an integer greater or equal to 1).

First, the MP3 decoder will be described.

The MP3 decoding core unit 310 extracts modified discrete cosine transform (MDCT) coefficients and additional information of a plurality of bands from an input MP3 bitstream, and generates filter bank values (a first through $n_{th}$ filter bank values) of the plurality of bands from the MDCT coefficients of the plurality of bands.

The first PQMF synthesizing unit 330 synthesizes the filter bank values (the first through $n_{th}$ filter bank values) of the plurality of bands, which were generated by the MP3 decoding core unit 310, and thus generates an audio stream on a time domain.

Next, the multi-channel decoder will be described.

The PQMF analyzing unit 340 divides the audio stream on the time domain, which is input from the MP3 decoder, into a plurality of sub-bands on a frequency domain.

The first-$n_{th}$ FFT units 351 through 354 perform a FFT on audio signals of the plurality of sub-bands for each sub-band, wherein the audio signals of the plurality of sub-bands are output from the PQMF analyzing unit 340.

The multi-channel decoding core unit 360 performs decoding on FFT coefficients, which are FFT-performed by the first-$n_{th}$ FFT units 351 through 354, of multi-channel sub-bands by using the additional information that is extracted from the MP3 decoding core unit 310.

The first-$n_{th}$ IFFT units 371 through 374 restores the FFT coefficients of multi-channel sub-bands decoded by the multi-channel decoding core unit 360 into audio signals of the sub-bands on the time domain.

The second PQMF synthesizing unit 380 generates a multi-channel audio signal by synthesizing the audio signals of the sub-bands, wherein the audio signals are restored by the first-$n_{th}$ IFFT units 371 through 374.

According to one or more exemplary embodiments of the present invention, the first PQMF synthesizing unit 330, the PQMF analyzing unit 340, and the second PQMF synthesizing unit 380, which have high complexity, in FIG. 3 are substituted with converters having low complexity.

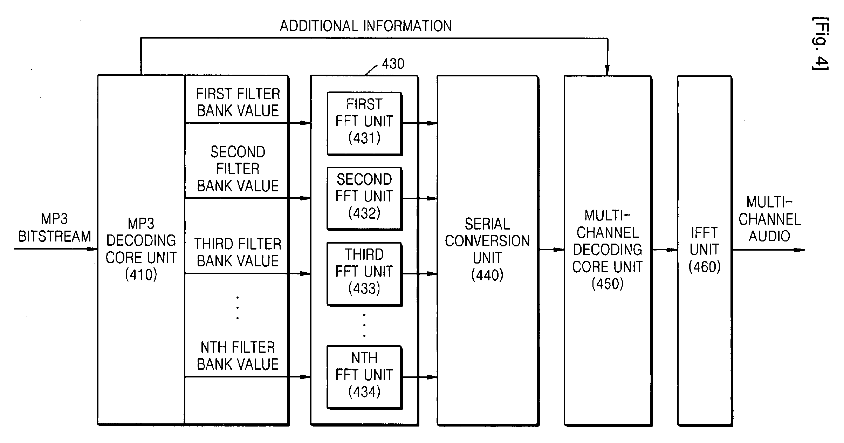

FIG. 4 is a diagram of a multi-channel decoding apparatus being compatible with a MP3 decoder, according to an exemplary embodiment of the present invention.

The multi-channel decoding apparatus in FIG. 4 includes a MP3 decoding core unit 410, an FFT unit 430, a serial conversion unit 440, a multi-channel decoding core unit 450, and an IFFT unit 460.

The MP3 decoding core unit 410 extracts MDCT coefficients and additional information from an input MP3 bitstream, and extracts filter bank values (a first through $n_{th}$ filter bank values) of a plurality of sub-bands from the MDCT coefficients. Here, the filter bank values of the plurality of sub-bands may use inverse MDCT (IMDCT) coefficients.

The FFT unit 430 performs a FFT on the filter bank values (the first through $n_{th}$ filter bank values) of the plurality of sub-bands for each sub-band by using first-$n_{th}$ FFT units 431 through 434, wherein the filter bank values are output from the MP3 decoding core unit 410. At this time, instead of the FFT, another frequency coefficient conversion such as a discrete Fourier transform (DFT) may be performed.

The serial conversion unit 440 compensates FFT coefficients of the sub-bands with respect to a phase shift due to aliasing components at borders of the sub-bands, wherein the FFT coefficients are FFT-performed with respect to each of the sub-bands. Then, the serial conversion unit 440 band-synthesizes the phase-compensated sub-bands in series in a frequency domain.

The multi-channel decoding core unit 450 upmixes the FFT coefficients, which are band-synthesized by the serial conversion unit 440, into a multi-channel FFT coefficient by using the additional information extracted by the MP3 decoding core unit 410. For example, the multi-channel decoding core unit 450 upmixes a band-synthesized audio signal into a multi-channel audio signal formed of 6 multiple channels that are a front-left channel, a front-right channel, a back-left channel, a back-right channel, a center channel, and a low frequency enhancement (LFE) channel.

The IFFT unit 460 restores the multi-channel FFT coefficient, which is decoded by the multi-channel decoding core unit 450, into a multi-channel audio signal on the time domain.

According to the exemplary embodiment, it is possible to improve the complexity of transformation of a signal by using the serial conversion unit 440, instead of using the first PQMF synthesizing unit 330, the PQMF analyzing unit 340, and the second PQMF synthesizing unit 380 according to the related art.

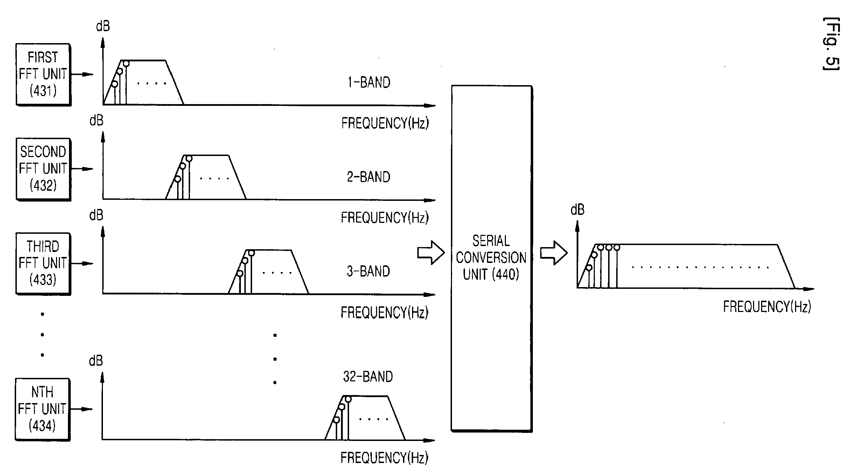

FIG. 5 is a diagram of a relationship between an input signal and an output signal in the serial conversion unit 440 in FIG. 4.

Referring to FIG. 5, the serial conversion unit 440 may generate an effect of performing a large point FFT by serially synthesizing FFT coefficients of a plurality of sub-bands by using the first-$n_{th}$ FFT units 431 through 434 of the FFT unit 430, wherein a small point FFT is performed on the audio signals in the sub-bands. For example, after a frequency band between 1Hz through 22kHz is divided into 32 sub-bands, each of 32 FFT unit 431 through 434 performs 128-point FFT. The serial conversion unit 440 takes FFT coefficients of 32 sub-band, whose bandwidth is about 1.3kHz, and eventually produces same result as a case in which a 4096-point FFT is performed on the whole frequency band between 1Hz through 22kHz corresponding to the 32 sub-bands.

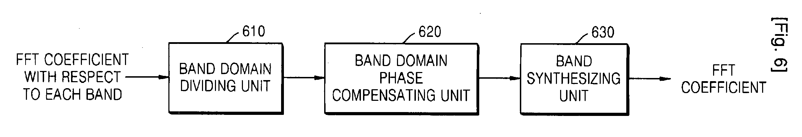

FIG. 6 is a detailed diagram of the serial conversion unit 440 in FIG. 4.

The serial conversion unit 440 in FIG. 4 includes a band domain dividing unit 610, a band domain phase compensating unit 620, and a band synthesizing unit 630.

The band domain dividing unit 610 divides a plurality of bands into even bands and odd bands, and divides each of the divided bands into a plurality of domains.

The band domain phase compensating unit 620 calculates phase shift values of the domains of the band domain dividing unit 610, based on a predetermined phase compensation value and a predetermined phase response value, and compensates for each phase of the bands of the plurality of domains by using the phase shift values of the domains.

The band synthesizing unit 630 serially synthesizes FFT coefficients of the even and odd bands which are phase-compensated by the band domain phase compensating unit 620.

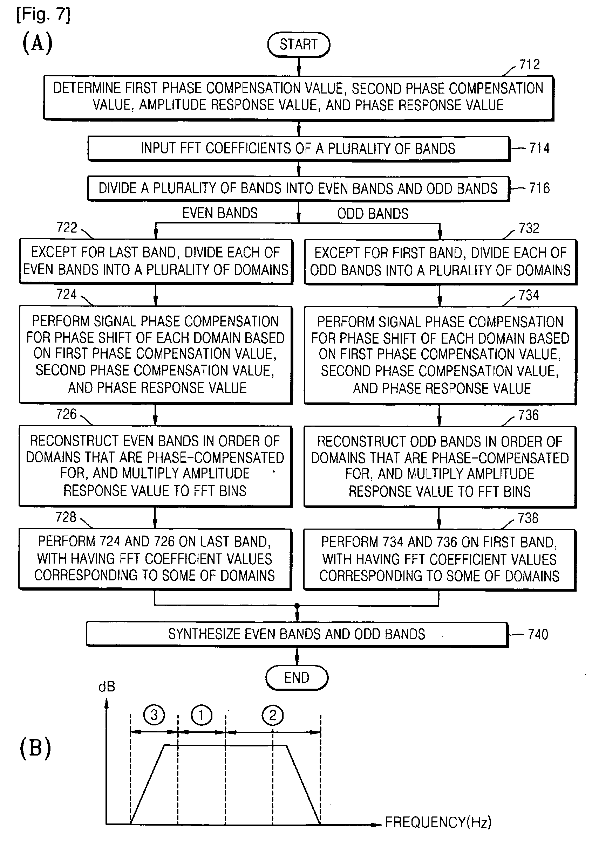

FIG. 7(A) is a detailed flowchart of operations performed by the serial conversion unit 440 in FIG. 4.

First, a first phase compensation value, a second phase compensation value, an amplitude response value, and a phase response value are appropriately determined by a user or according to a test value (operation 712). Here, the first phase compensation value is a value involving compensating for a phase shift of a signal duplicated from an original signal, and the second phase compensation value is a value involving converting a signal phase value according to a Z-transform into a signal phase value according to a FFT. Also, the amplitude response value and the phase response value are applied a low pass prototype filter of the PQMF of MP3.

First, FFT coefficients of a plurality of bands are input (operation 714). For example, FFT coefficients of 32 bands are input.

Then, the 32 bands are divided into even bands and odd bands (operation 716).

Except for the $32_{nd}$ band, each of the even bands is divided into a plurality of domains (operation 722). For example, it is assumed that each band is divided into three domains. Then, as illustrated in FIG. 7(B), a first domain ① is set as a $1/4^{th}$ FFT coefficient through a $1/2^{nd}$ FFT coefficient in a band, a second domain ② is set as the $1/2^{nd}$ FFT coefficient through a last FFT coefficient in the band, and a third domain ③ is set as a first FFT coefficient through the $1/4^{th}$ FFT coefficient in the band.

Then, phase compensation for a phase shift of each domain is performed based on the first phase compensation value, the second phase compensation value, and the phase response value (operation 724). For example, phase shift values of the first, second, and third domains ①, ②, and ③ are determined by using Equations 1, 2, and 3. Here, M indicates a length of each band.

[Equation 1]

phase shift of a first domain = first phase compensation value x (M/4 ~ 1) + second phase compensation value x (index of each band-1)/2 + phase response value - $\pi$

[Equation 2]

phase shift of a second domain = first phase compensation value x (0 ~ M/2) + second phase compensation value x (index of each band-1)/2 + phase response value + $\pi$

[Equation 3]

phase shift of a third domain = first phase compensation value x (M/2 ~ M/4) +

second phase compensation value x (index of each band-1)/2 + phase response value -

$\pi$

Then, the even bands are reconstructed in an order of the even bands of which the domains have undergone the phase compensation according to operations 712 through 724, and the predetermined amplitude response value is multiplied to FFT bins of each domain (operation 726). That is, a phase of each band is compensated for by using the phase shift values of the first, second, and third domains ①, ②, and ③.

After that, with the FFT coefficients corresponding to the first and second domains ① and ②, operations 724 and 726 are performed on the 32nd band (operation 728). Here, a phase of the 32nd band is compensated for by using the amplitude response value and the phase response value which correspond to 1 ~ M/4 domain.

Meanwhile, except for the first band, each of the odd bands is divided into three domains (operation 732). For example, the first domain is set as a 3/4th FFT coefficient through a last FFT coefficient in a band, the second domain is set as a first FFT coefficient through a 1/2nd FFT coefficient in the band, and the third domain is set as the 1/2nd FFT coefficient through the 3/4th FFT coefficient in the band.

Then, phase compensation for a phase shift of each domain is performed based on the first phase compensation value, the second phase compensation value, and the phase response value (operation 734). For example, phase shift values of the first, second, and third domains are determined by using Equations 4, 5, and 6. Here, M indicates a length of each band.

[Equation 4]

phase shift of a first domain = first phase compensation value x (M/4 ~ 1) + second phase compensation value x (index of each band-1)/2 + phase response value

[Equation 5]

phase shift of a second domain = first phase compensation value x (0 ~ M/2) + second phase compensation value x (index of each band-1)/2 + phase response value

[Equation 6]

phase shift of a third domain = first phase compensation value x (M/2 ~ M/4) + second phase compensation value x (index of each band-1)/2 + phase response value

Then, the even bands are reconstructed in an order of the odd bands of which the domains have undergone the phase compensation according to operations 732 and 734, and the predetermined amplitude response value is multiplied to FFT bins of each domain (operation 736). That is, a phase of each band is compensated for by using the phase shift values of the first, second, and third domains.

After that, with having the FFT coefficients corresponding to the second and third domains, operations 734 and 736 are performed on the 1st band (operation 738). Here, a phase of the 1st band is compensated for by using the amplitude response value and the phase response value which correspond to M/4~M domain.

Thus, according to an exemplary embodiment of the present embodiment, in order to remove the aliasing components 330 generated by downsampling as illustrated in FIG. 2(D), the phase shift is compensated with respect to each domain.

Finally, the 32 bands divided into the even and odd bands are synthesized in series on a frequency domain (operation 740).

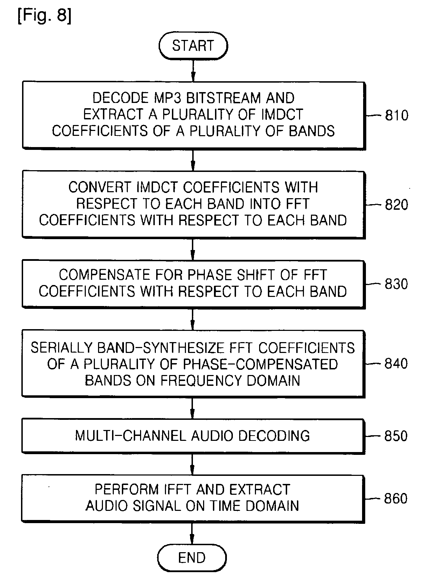

FIG. 8 is a flowchart of a multi-channel audio signal decoding method being compatible with a MP3 decoder, according to an exemplary embodiment of the present invention.

First, a bitstream having a predetermined format is decoded to extract filter bank values of the plurality of sub-bands (IMDCT coefficients of the plurality of sub-bands) (operation 810). The bitstream having the predetermined format may be an MP3 bitstream.

The filter bank values of the plurality of sub-bands are converted into FFT coefficients with respect to each band by performing an FFT (operation 820).

Then, phases of the FFT coefficients of each band are shifted by using a phase compensation value and a phase response value, and thus phase shifts due to aliasing components at borders of a plurality of bands are compensated for (operation 830).

The FFT coefficients of the plurality of signal-phase compensated bands are band-synthesized in series on a frequency domain (operation 840).

Then, multi-channel audio decoding is performed on the band-synthesized FFT coefficients so as to extract multi-channel FFT coefficients (operation 850).

To be more specific, band-synthesized frequency-transformed coefficients are upmixed to multi-channel frequency-transformed coefficients by using additional information decoded from an MP3 bitstream, and a multi-channel audio signal on a time domain is restored from the multi-channel frequency-transformed coefficients.

Then, an inverse FFT is performed to convert the multi-channel FFT coefficients into the multi-channel audio signal on a time domain (operation 860).

[Industrial Applicability]

The invention can also be embodied as computer readable codes on a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, optical data storage devices, etc. The computer readable recording medium can also be distributed over network coupled computer systems so that the computer readable code is stored and executed in a distributed fashion. Also, functional programs, codes, and code segments for accomplishing the present invention can be easily construed by programmers skilled in the art to which the present invention pertains.

**Claims**

1. A multi-channel audio decoding method comprising:

   extracting (810) filter bank coefficients of a plurality of bands from a bitstream of a predetermined format;
   performing frequency transformation on the extracted filter bank coefficients of the plurality of bands to output (820) frequency-transformed coefficients of the plurality of bands;
   compensating (830) for phases of the plurality of bands according to a predetermined phase compensation value, and serially band-synthesizing (840) the frequency-transformed coefficients of the plurality of bands in a frequency domain; and
   decoding (850) a multi-channel audio signal from the serially band-synthesized frequency-transformed coefficients.

2. The multi-channel audio decoding method of claim 1, wherein the bitstream of the predetermined format is an MPEG-1 Audio Layer 3 (MP3) bitstream.

3. The multi-channel audio decoding method of claim 1, wherein the serially band-synthesizing comprises performing a large point Fast Fourier transform (FFT) on FFT coefficients of the plurality of bands, wherein a small point FFT is performed on the audio signals.

4. The multi-channel audio decoding method of claim 1, wherein the filter bank coefficients of the plurality of bands are inverse modified discrete cosine transform (IMDCT) coefficients.

5. The multi-channel audio decoding method of claim 1, wherein the compensating for the phases comprises removing aliasing components at borders of the plurality of bands, wherein the aliasing components are generated by downsampling audio signals of the plurality of bands via a Pseudo-Quadrature Mirror Filter (PQMF) of an MP3 decoder.

6. The multi-channel audio decoding method of claim 1, wherein the serially band-synthesizing comprises:

   setting a phase compensation value and a phase respond value;
   dividing the plurality of bands into even bands and odd bands, and dividing each of the divided plurality of bands into a plurality of domains;

calculating phase shift values of the plurality of domains based on the phase compensation value and the phase respond value, and compensating for phases of the plurality of bands according to the calculated phase shift values; and

serially synthesizing the phase-compensated plurality of bands.

7. The multi-channel audio decoding method of claim 6, further comprising multiplying a predetermined amplitude respond value to the plurality of phase-compensated plurality of bands.

8. The multi-channel audio decoding method of claim 6, wherein the phase compensation value comprises a first phase compensation value set to compensate for a phase shift of a signal duplicated from an original signal, and a second phase compensation value involving converting a signal phase value according to a Z-transform into a signal phase value according to a Fast Fourier transform (FFT).

9. The multi-channel audio decoding method of claim 6, wherein the serially synthesizing comprises reconstructing the plurality of bands in an order of the plurality of domains of the plurality of phase-compensated bands, and synthesizing the reconstructed plurality of bands.

10. The multi-channel audio decoding method of claim 6, wherein the compensating for the phases comprises obtaining different phase shift values with respect to the even bands, the odd bands, and the plurality of domains.

11. The multi-channel audio decoding method of claim 1, wherein the decoding of the multi-channel audio signal comprises upmixing the serially band-synthesized frequency-transformed coefficients to multi-channel frequency-transformed coefficients by using additional information decoded from the bitstream having the predetermined format, and restoring a multi-channel audio signal in a time domain from the multi-channel frequency-transformed coefficients.

12. A multi-channel audio decoding apparatus comprising:

an MPEG-1 Audio Layer 3 (MP3) decoding core unit (410) which extracts filter bank coefficients of a plurality of bands from an MP3 bitstream;

a Fast Fourier transform (FFT) unit (430) which performs FFT on the extracted filter bank coefficients of the plurality of bands;

a serial conversion unit (440) which shifts phases of the plurality of bands which are FFT-performed by the FFT unit, according to a predetermined phase compensation value, and serially band-synthesizing FFT coefficients of the plurality of bands in a frequency domain; and

a multi-channel decoding core unit (450) which decodes a multi-channel audio signal from the FFT coefficients that are serially band-synthesized by the serial conversion unit.

13. The multi-channel audio decoding apparatus of claim 12, wherein the serial conversion unit comprises:

a band domain dividing unit which divides the plurality of bands into even bands and odd bands, and divides the plurality of divided bands into a predetermined number of domains;

a band domain phase compensating unit which calculates phase shift values of the plurality of domains, based on the predetermined phase compensation value and a predetermined phase respond value, and compensates for the phases the plurality of bands according to the calculated phase shift values; and

a band synthesizing unit which serially synthesizes the FFT coefficients of the even and odd bands which are phase-compensated by the band domain phase compensating unit.

14. A computer readable recording medium having recorded thereon a program for executing the method of a multi-channel audio decoding, the method comprising:

extracting filter bank coefficients of a plurality of bands from a bitstream of a predetermined format;

performing frequency transformation on the extracted filter bank coefficients of the plurality of bands to output frequency-transformed coefficients of the plurality of bands;

compensating for phases of the plurality of bands according to a predetermined phase compensation value, and serially band-synthesizing the frequency-transformed coefficients of the plurality of bands in a frequency domain; and

decoding a multi-channel audio signal from the serially band-synthesized frequency-transformed coefficients.

**Patentansprüche**

1.  Mehrkanal-Audiodecodierverfahren, umfassend:

    Extrahieren (810) von Filterbankkoeffizienten einer Mehrzahl von Bändern aus einem Bitstrom eines vorbestimmten Formats;
    Durchführen von Frequenzumwandlung an den extrahierten Filterbankkoeffizienten der Mehrzahl von Bändern, um frequenzgewandelte Koeffizienten der Mehrzahl von Bändern auszugeben (820);
    Kompensieren (830) von Phasen der Mehrzahl von Bändern gemäß einem vorbestimmten Phasenkompensationswert und serielles Bandsynthetisieren (840) der frequenzgewandelten Koeffizienten der Mehrzahl von Bändern in einem Frequenzbereich; und
    Decodieren (850) eines Mehrkanal-Audiosignals aus den seriell bandsynthetisierten, frequenzgewandelten Koeffizienten.

2.  Mehrkanal-Audiodecodierverfahren nach Anspruch 1, wobei der Bitstrom des vorbestimmten Formats ein Bitstrom einer MPEG-1 Audio-Schicht 3 (MP3) ist.

3.  Mehrkanal-Audiodecodierverfahren nach Anspruch 1, wobei das serielle Bandsynthetisieren ein Durchführen einer schnellen Großpunkt-Fourier-Transformation (FFT) an FFT-Koeffizienten der Mehrzahl von Bändern umfasst, wobei an den Audiosignalen eine Kleinpunkt-FFT durchgeführt wird.

4.  Mehrkanal-Audiodecodierverfahren nach Anspruch 1, wobei die Filterbankkoeffizienten der Mehrzahl von Bändern Koeffizienten einer inversen modifizierten diskreten Cosinus-Transformation (IMDCT) sind.

5.  Mehrkanal-Audiodecodierverfahren nach Anspruch 1, wobei das Kompensieren der Phasen ein Entfernen von Aliasing-Komponenten an Rändern der Mehrzahl von Bändern umfasst, wobei die Aliasing-Komponenten durch Unterabtasten von Audiosignalen der Mehrzahl von Bändern über ein Pseudo-Quadratur-Spiegelfilter (PQMF) eines MP3-Decoders erzeugt werden.

6.  Mehrkanal-Audiodecodierverfahren nach Anspruch 1, wobei das serielle Bandsynthetisieren umfasst:

    Setzen eines Phasenkompensationswerts und eines Phasenantwortwerts;
    Teilen der Mehrzahl von Bändern in gerade Bänder und ungerade Bänder und Teilen jedes der geteilten Mehrzahl von Bändern in eine Mehrzahl von Bereichen;
    Berechnen von Phasenverschiebungswerten der Mehrzahl von Bereichen basierend auf dem Phasenkompensationswert und dem Phasenantwortwert und Kompensieren von Phasen der Mehrzahl von Bändern gemäß den berechneten Phasenverschiebungswerten; und
    serielles Synthetisieren der phasenkompensierten Mehrzahl von Bändern.

7.  Mehrkanal-Audiodecodierverfahren nach Anspruch 6, ferner umfassend ein Multiplizieren eines vorbestimmten Amplitudenantwortwerts mit der Mehrzahl der phasenkompensierten Mehrzahl von Bändern.

8.  Mehrkanal-Audiodecodierverfahren nach Anspruch 6, wobei der Phasenkompensationswert einen ersten Phasenkompensationswert, der zum Kompensieren einer Phasenverschiebung eines aus einem ursprünglichen Signal duplizierten Signals gesetzt wird, und einen zweiten Phasenkompensationswert umfasst, der ein Konvertieren eines Signalphasenwerts gemäß einer Z-Transformation in einen Signalphasenwert gemäß einer schnellen Fourier-Transformation (FFT) umfasst.

9.  Mehrkanal-Audiodecodierverfahren nach Anspruch 6, wobei das serielle Synthetisieren ein Wiederherstellen der Mehrzahl von Bändern in einer Reihenfolge der Mehrzahl von Bereichen der Mehrzahl von phasenkompensierten Bändern und Synthetisieren der wiederhergestellten Mehrzahl von Bändern umfasst.

10. Mehrkanal-Audiodecodierverfahren nach Anspruch 6, wobei das Kompensieren der Phasen ein Einholen von verschiedenen Phasenverschiebungswerten in Bezug auf die geraden Bänder, die ungeraden Bänder und die Mehrzahl von Bereichen umfasst.

**11.** Mehrkanal-Audiodecodierverfahren nach Anspruch 1, wobei das Decodieren des Mehrkanal-Audiosignals ein Hochmischen der seriell bandsynthetisierten, frequenzgewandelten Koeffizienten auf frequenzgewandelte Mehrkanalkoeffizienten durch Verwenden von zusätzlichen, aus dem Bitstrom mit dem vorbestimmten Format decodierten Informationen und Wiederherstellen eines Mehrkanal-Audiosignals in einem Zeitbereich aus den frequenzgewandelten Mehrkanalkoeffizienten umfasst.

**12.** Mehrkanal-Audiodecodiervorrichtung, umfassend:

eine Kerneinheit (410) zur MP3 (MPEG-1 Audio-Schicht 3)-Decodierung, welche Filterbankkoeffizienten einer Mehrzahl von Bändern aus einem MP3-Bitstrom extrahiert;
eine FFT (schnelle Fourier-Transformation)-Einheit (430) welche FFT an den extrahierten Filterbankkoeffizienten der Mehrzahl von Bändern durchführt;
eine Einheit für serielle Konversion (440), welche Phasen der Mehrzahl von Bändern, an welchen die FFT-Einheit FFT durchführt, gemäß einem vorbestimmten Phasenkompensationswert verschiebt und FFT-Koeffizienten der Mehrzahl von Bändern in einem Frequenzbereich seriell bandsynthetisiert; und
eine Mehrkanaldecodierungs-Kerneinheit (450), die ein Mehrkanal-Audiosignal aus den von der Einheit für serielle Konversion seriell bandsynthetisierten FFT-Koeffizienten decodiert.

**13.** Mehrkanal-Audiodecodiervorrichtung nach Anspruch 12, wobei die Einheit für serielle Konversion umfasst:

eine Bandbereichsteilungseinheit, welche die Mehrzahl von Bändern in gerade Bänder und ungerade Bänder teilt und die Mehrzahl von geteilten Bändern in eine vorbestimmte Anzahl von Bereichen teilt;
eine Bandbereichs-Phasenkompensationseinheit, welche Phasenverschiebungswerte der Mehrzahl von Bereichen basierend auf dem vorbestimmten Phasenkompensationswert und einem vorbestimmten Phasenantwortwert berechnet und Phasen der Mehrzahl von Bändern gemäß den berechneten Phasenverschiebungswerten kompensiert; und
eine Bandsyntheseeinheit, welche die FFT-Koeffizienten der geraden und ungeraden Bändern, die von der Bandbereichs-Phasenkompensationseinheit phasenkompensiert werden, seriell synthetisiert.

**14.** Computerlesbares Aufzeichnungsmedium mit einem darauf aufgezeichneten Programm zum Ausführen des Verfahrens zur Mehrkanal-Audiodecodierung, wobei das Verfahren umfasst:

Extrahieren von Filterbankkoeffizienten einer Mehrzahl von Bändern aus einem Bitstrom eines vorbestimmten Formats;
Durchführen von Frequenzumwandlung an den extrahierten Filterbankkoeffizienten der Mehrzahl von Bändern, um frequenzgewandelte Koeffizienten der Mehrzahl von Bändern auszugeben;
Kompensieren von Phasen der Mehrzahl von Bändern gemäß einem vorbestimmten Phasenkompensationswert und serielles Bandsynthetisieren der frequenzgewandelten Koeffizienten der Mehrzahl von Bändern in einem Frequenzbereich; und
Decodieren eines Mehrkanal-Audiosignals aus den seriell bandsynthetisierten, frequenzgewandelten Koeffizienten.

## Revendications

**1.** Procédé de décodage audio multicanal comprenant les étapes suivantes :

extraire (810), d'un train de bits d'un format prédéterminé, des coefficients de banque de filtres d'une pluralité de bandes ;
effectuer une transformation de fréquence sur les coefficients de banque de filtres extraits de la pluralité de bandes pour délivrer en sortie (820) des coefficients à fréquence transformée de la pluralité de bandes ;
compenser (830) les phases de la pluralité de bandes conformément à une valeur de compensation de phase prédéterminée, et synthétiser en bande (840) en série les coefficients à fréquence transformée de la pluralité de bandes dans un domaine de fréquences ; et décoder (850) un signal audio multicanal à partir des coefficients à fréquence transformée synthétisés en bande en série.

**2.** Procédé de décodage audio multicanal selon la revendication 1, dans lequel le train de bits du format prédéterminé est un train de bits MPEG-1 Audio Layer 3 (MP3).

3.  Procédé de décodage audio multicanal selon la revendication 1, dans lequel la synthèse en bande en série comprend de procéder à une transformée de Fourier rapide (FFT) à gros point sur des coefficients FFT de la pluralité de bandes, où une FFT à petit point est effectuée sur les signaux audio.

4.  Procédé de décodage audio multicanal selon la revendication 1, dans lequel les coefficients de banque de filtres de la pluralité de bandes sont des coefficients de transformée cosinus discrète modifiée inverse (IMDCT).

5.  Procédé de décodage audio multicanal selon la revendication 1, dans lequel la compensation des phases comprend d'éliminer des composantes de repliement aux frontières de la pluralité de bandes, où les composantes de repliement sont générées par un sous-échantillonnage des signaux audio de la pluralité de bandes par l'intermédiaire d'un filtre miroir en pseudo quadrature (PQMF) d'un décodeur MP3.

6.  Procédé de décodage audio multicanal selon la revendication 1, dans lequel la synthèse en bande en série comprend les étapes suivantes :

    définir une valeur de compensation de phase et une valeur de réponse de phase ;
    diviser la pluralité de bandes en bandes paires et en bandes impaires, et diviser chacune de la pluralité de bandes divisées en une pluralité de domaines ;
    calculer des valeurs de déphasage de la pluralité de domaines sur la base de la valeur de compensation de phase et de la valeur de réponse de phase, et compenser les phases de la pluralité de bandes conformément aux valeurs de déphasage calculées ; et
    synthétiser en série la pluralité de bandes à phase compensée.

7.  Procédé de décodage audio multicanal selon la revendication 6, comprenant en outre de multiplier une valeur de réponse d'amplitude prédéterminée par la pluralité de bandes à phase compensée.

8.  Procédé de décodage audio multicanal selon la revendication 6, dans lequel la valeur de compensation de phase comprend une première valeur de compensation de phase définie pour compenser un déphasage d'un signal dupliqué à partir d'un signal original, et une seconde valeur de compensation de phase impliquant la conversion d'une valeur de phase de signal conformément à une transformée en Z en une valeur de phase de signal conformément à une transformée de Fourier rapide (FFT).

9.  Procédé de décodage audio multicanal selon la revendication 6, dans lequel la synthèse en série comprend de reconstruire la pluralité de bandes dans un ordre de la pluralité de domaines de la pluralité de bandes à phase compensée, et de synthétiser la pluralité de bandes reconstruite.

10. Procédé de décodage audio multicanal selon la revendication 6, dans lequel la compensation des phases comprend d'obtenir différentes valeurs de déphasage par rapport aux bandes paires, aux bandes impaires et à la pluralité de domaines.

11. Procédé de décodage audio multicanal selon la revendication 1, dans lequel le décodage du signal audio multicanal comprend de procéder à un mixage montant des coefficients à fréquence transformée synthétisés en bande en série en des coefficients à fréquence transformée multicanaux au moyen d'informations supplémentaires décodées à partir du train de bits ayant le format prédéterminé, et de rétablir un signal audio multicanal dans un domaine temporel à partir des coefficients à fréquence transformée multicanaux.

12. Appareil de décodage audio multicanal comprenant :

    une unité centrale de décodage MPEG-1 Audio Layer 3 (MP3) (410) qui extrait des coefficients de banque de filtres d'une pluralité de bandes d'un train de bits MP3 ;
    une unité de transformée de Fourier rapide (FFT) (430) qui effectue une FFT sur les coefficients de banque de filtres extraits de la pluralité de bandes ;
    une unité de conversion série (440) qui décale les phases de la pluralité de bandes auxquelles une FFT a été appliquée par l'unité FFT, conformément à une valeur de compensation de phase prédéterminée, et à des coefficients FFT de synthèse en bande en série de la pluralité de bandes dans un domaine de fréquences ; et
    une unité centrale de décodage multicanal (450) qui décode un signal audio multicanal à partir des coefficients FFT qui sont synthétisés en bande en série par l'unité de conversion en série.

**13.** Appareil de décodage audio multicanal selon la revendication 12, dans lequel l'unité de conversion en série comprend :

une unité de division de domaine de bandes qui divise la pluralité de bandes en bandes paires et en bandes impaires, et divise la pluralité de bandes divisées en un nombre prédéterminé de domaines ;
une unité de compensation de phase de domaine de bandes qui calcule des valeurs de déphasage de la pluralité de domaines, sur la base de la valeur de compensation de phase prédéterminée et d'une valeur de réponse de phase prédéterminée, et compense les phases de la pluralité de bandes conformément aux valeurs de déphasage calculées ; et
une unité de synthèse de bandes qui synthétise en série les coefficients FFT des bandes paires et impaires qui ont leur phase compensée par l'unité de compensation de phase de domaine de bandes.

**14.** Support d'enregistrement lisible par ordinateur sur lequel est enregistré un programme pour exécuter le procédé d'un décodage audio multicanal, le procédé comprenant les étapes suivantes :

extraire, d'un train de bits d'un format prédéterminé, des coefficients de barique de filtres d'une pluralité de bandes ;
effectuer une transformation de fréquence sur les coefficients de banque de filtres extraits de la pluralité de bandes pour délivrer en sortie des coefficients à fréquence transformée de la pluralité de bandes ;
compenser les phases de la pluralité de bandes conformément à une valeur de compensation de phase prédéterminée, et synthétiser en bande en série les coefficients à fréquence transformée de la pluralité de bandes dans un domaine de fréquences ; et
décoder un signal audio multicanal à partir des coefficients à fréquence transformée synthétisés en bande en série.

[Fig. 1]

## (A)

## (B)

[Fig. 2]

[Fig. 3]

[Fig. 4]

[Fig. 5]

[Fig. 6]

```
FFT COEFFICIENT        ┌─────────────┐   ┌─────────────┐   ┌─────────────┐      FFT
WITH RESPECT ─────────→│ BAND DOMAIN │──→│ BAND DOMAIN │──→│    BAND     │───→ COEFFICIENT
TO EACH BAND           │DIVIDING UNIT│   │   PHASE     │   │ SYNTHESIZING│
                       │             │   │COMPENSATING │   │    UNIT     │
                       └─────────────┘   │    UNIT     │   └─────────────┘
                         ╱610            └─────────────┘     ╱630
                                           ╱620
```

[Fig. 7]

**(A)**

**(B)**

[Fig. 8]

```
                    ┌─────────────┐
                    │    START    │
                    └──────┬──────┘
                           │
                           ▼
          ┌────────────────────────────────┐
          │    DECODE MP3 BITSTREAM AND     │
          │  EXTRACT A PLURALITY OF IMDCT   │──── 810
          │  COEFFICIENTS OF A PLURALITY OF BANDS │
          └────────────────┬───────────────┘
                           │
                           ▼
          ┌────────────────────────────────┐
          │   CONVERT IMDCT COEFFICIENTS WITH │
          │   RESPECT TO EACH BAND INTO FFT   │──── 820
          │   COEFFICIENTS WITH RESPECT TO EACH BAND │
          └────────────────┬───────────────┘
                           │
                           ▼
          ┌────────────────────────────────┐
          │   COMPENSATE FOR PHASE SHIFT OF FFT │──── 830
          │  COEFFICIENTS WITH RESPECT TO EACH BAND │
          └────────────────┬───────────────┘
                           │
                           ▼
          ┌────────────────────────────────┐
          │ SERIALLY BAND-SYNTHESIZE FFT COEFFICIENTS │
          │  OF A PLURALITY OF PHASE-COMPENSATED │──── 840
          │     BANDS ON FREQUENCY DOMAIN     │
          └────────────────┬───────────────┘
                           │
                           ▼
          ┌────────────────────────────────┐
          │    MULTI-CHANNEL AUDIO DECODING   │──── 850
          └────────────────┬───────────────┘
                           │
                           ▼
          ┌────────────────────────────────┐
          │      PERFORM IFFT AND EXTRACT     │──── 860
          │     AUDIO SIGNAL ON TIME DOMAIN   │
          └────────────────┬───────────────┘
                           │
                           ▼
                    ┌─────────────┐
                    │     END     │
                    └─────────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008002842 A